# DEMANDE DE BREVET EUROPEEN

(11) **EP 1 328 012 A1**
(43) Date de publication de la demande: **16.07.2003**
(21) Numéro de dépôt: 02356230.9
(22) Date de dépôt: 18.11.2002
(51) Int. Cl.: H01L 21/02, H01L 27/08

(54) **Procédé de fabrication d'un composant électronique incorporant un microcomposantinductif**

(30) Priorité: 29.11.2001 FR 0115456
(71) Demandeur: Memscap, 38190 Bernin (FR)
(72) Inventeur: Girardie, Lionel, 38320 Eybens (FR); David, Jean-Baptiste, 38400 Saint Martin D'heres (FR)
(74) Mandataire: Palix, Stéphane

(57) **Abrégé**

L'invention concerne un procédé permettant de fabriquer des composants électroniques incorporant un micro-composant inductif, disposé au dessus d'un substrat.

Un tel composant comporte :
- une couche (10) de matériau à faible permittivité relative, reposant sur la face supérieure du substrat (1) ;
- un ensemble de spires métalliques (30-31), définies au-dessus de la couche (10) de matériau à faible permittivité relative ;
- une couche (15) barrière à la diffusion du cuivre, interposée entre les spires métalliques (30-31) et la couche de matériau à faible permittivité relative.

## Description

### Domaine Technique

L'invention se rattache au domaine de la microélectronique. Plus précisément, elle vise un procédé permettant de réaliser des micro-composants inductifs sur un substrat, qui peut lui-même incorporer un circuit intégré.

Ces composants peuvent notamment être utilisés dans les applications de type radiofréquences, par exemple dans le domaine des télécommunications.

L'invention vise plus spécifiquement un procédé permettant d'obtenir des circuits possédant des performances nettement plus élevées que les composants existants, notamment en ce qui concerne la valeur du facteur de qualité. Le procédé objet de l'invention, limite également le nombre d'étapes nécessaires pour la réalisation de tels composants, et assure une bonne reproductibilité des caractéristiques des composants qu'il permet de fabriquer.

### Techniques antérieures

Dans le document FR 2 791 470, le Demandeur a décrit un procédé de fabrication permettant de réaliser des micro-inductances ou des microtransformateurs au-dessus d'un substrat, et notamment au-dessus d'un circuit intégré. De façon résumée, ce procédé consiste à déposer une couche de matériau de faible permittivité relative puis à réaliser une gravure de ce matériau au niveau d'une ouverture réalisée dans un masque dur, à l'aplomb d'un plot de connexion avec le reste du circuit intégré, de manière à définir un trou d'interconnexion, également appelé "via"

Après avoir déposé une résine au-dessus du masque dur, on grave cette dernière pour former les canaux définissant la géométrie des spires du composant inductif. On procède par la suite à un dépôt de cuivre, par voie électrolytique, au-dessus du plot de connexion, et dans les canaux définis dans la résine supérieure.

Un tel procédé présente un certain nombre d'inconvénients, parmi lesquels on peut noter essentiellement le fait que l'étape de dépôt électrolytique assure à la fois la formation des spires du composant inductif, ainsi que le remplissage du trou d'interconnexion, permettant le contact avec le plot métallique relié au circuit intégré. Ces zones étant de profondeurs différentes, il s'ensuit que le dépôt électrolytique s'effectue de manière différente au niveau des spires et au niveau du trou d'interconnexion. On observe ainsi certaines irrégularités au niveau de la formation des spires qui sont préjudiciables à la bonne régularité des performances électriques du composant inductif.

En outre, lors de l'étape de gravure de la résine supérieure, il est nécessaire d'effectuer une gravure plus longue au niveau du trou d'interconnexion, par comparaison avec les zones dans lesquelles sont formés les canaux destinés à recevoir les spires. Cette différence de profondeur de gravure provoque une libération de composés chimiques au niveau du fond du trou d'interconnexion, ce qui perturbe l'opération ultérieure de dépôt électrolytique de cuivre.

Un des objectifs de l'invention est de pallier ces différents inconvénients, et notamment de permettre de réaliser des composants qui possèdent des caractéristiques dimensionnelles aussi précises que possible, de manière à conférer des performances électriques optimales.

### Exposé de l'invention

L'invention concerne donc un procédé de fabrication d'un composant électronique. Un tel composant incorpore un micro-composant inductif, tel qu'une inductance ou un transformateur, qui est situé au-dessus d'un substrat, et relié à ce substrat au moins par un plot métallique.

Conformément à l'invention, ce procédé se caractérise en ce qu'il comporte les étapes suivantes :
a) déposer sur le substrat une couche de matériau à faible permittivité relative ;
b) déposer une couche formant un masque dur ;
c) réaliser une ouverture dans le masque dur, à l'aplomb des plots métalliques ;
d) graver la couche de matériau à faible permittivité relative jusqu'au plot métallique, pour former un trou d'interconnexion ;
e) déposer une couche formant barrière à la diffusion du cuivre ;
f) déposer une couche amorce de cuivre ;
g) déposer un masque de protection, et à l'éliminer au niveau du trou d'interconnexion ;
h) déposer du cuivre, par voie électrolytique, dans le trou d'interconnexion ;
i) éliminer le reste du masque de protection ;
j) déposer une couche de résine supérieure d'une épaisseur voisine de l'épaisseur des spires du micro-composant inductif ;
k) graver la couche de résine supérieure pour former des canaux définissant la géométrie des spires du micro-composant inductif ;
l) déposer du cuivre par voie électrolytique dans les canaux ainsi gravés ;
m) éliminer le reste de la couche de résine supérieure ;
n) graver la couche amorce de cuivre entre les spires de cuivre ;
o) graver la couche barrière à la diffusion du cuivre entre les spires du micro-composant inductif.

Ainsi, le procédé conforme à l'invention enchaîne un certain nombre d'étapes qui procurent certaines améliorations par rapport aux procédés de l'Art antérieur. On notera notamment que le dépôt électrolytique de cuivre intervient en deux étapes distinctes, à savoir tout d'abord une première étape permettant de combler le trou d'interconnexion, ce qui permet dans un premier temps de faire croître du cuivre jusqu'au niveau du plan inférieur du micro-composant inductif. Dans une seconde étape, on procède à un dépôt électrolytique de cuivre, qui forme simultanément les spires du composant inductif et la zone de liaison des spires avec la via déjà comblée dans l'étape de dépôt antérieur.

De la sorte, en dissociant ces deux dépôts de cuivre, on assure une homogénéité de ce dépôt qui est favorable à la régularité de la forme des spires, et donc à la qualité des performances électriques ainsi qu'à la reproductibilité du procédé.

On notera également que ce procédé peut être utilisé sur différents types de substrat. Ainsi, dans une première famille d'application, le procédé peut être mis en oeuvre sur un substrat semi-conducteur, et notamment un substrat ayant été préalablement fonctionnalisé pour former un circuit intégré.

Dans d'autres types d'applications, il peut s'agir d'un substrat spécifique, tel qu'un substrat amorphe du type verre ou quartz, ou plus généralement un substrat possédant des propriétés électriques, optiques ou magnétiques appropriées à certaines applications.

En pratique, le matériau de faible permittivité relative, qui est déposé sur le substrat peut être du benzocyclobutène (BCB), ou voire encore un matériau analogue, dont la permittivité relative est typiquement inférieure à 3.

En pratique, l'épaisseur de cette couche de matériau de faible permittivité relative peut être comprise entre 10 et 40 micromètres, étant préférentiellement voisine de 20 micromètres.

L'épaisseur de cette couche définit sensiblement l'éloignement entre le composant inductif et le substrat. Cette distance, combinée avec la permittivité relative du matériau de cette couche définit la capacité parasite existant entre le composant inductif et le substrat, capacité qu'il est hautement souhaitable de minimiser.

En pratique, le matériau utilisé pour former le masque dur au-dessus du BCB peut être choisi dans le groupe comprenant : SiC, SiOC, SiN, SiON, Si₃N₄, SiO₂, Y₂O₃, Cr pris isolément ou en combinaison.

Ces matériaux présentent des propriétés de bonne compatibilité avec le BCB, notamment une forte adhésion comme masque dur sur la surface du BCB. Ces matériaux présentent des propriétés mécaniques adéquates pour leur utilisation en masquinage, ce qui évite l'apparition de trop fortes contraintes au niveau de la jonction entre le masque dur et la couche sous-jacente de BCB. Par ailleurs, par un choix judicieux de ces matériaux ayant pour fonction de masque dur à des fins de gravure des trous d'interconnexion, une sélectivité élevée de la gravure du BCB par rapport à ces matériaux est acquise, de manière à éviter toute sur-gravure du BCB et obtenir ainsi les profiles souhaités sans délaminage.

Les contraintes entre le BCB et le masque dur pourraient en effet se transmettre jusqu'au substrat et provoquer d'éventuelles ruptures de ce dernier. Ces phénomènes de trop fortes contraintes sont notamment observées dans les procédés de l'Art antérieur qui utilisent des couches épaisses de certains métaux pour réaliser le masque dur au-dessus d'une couche de BCB avec pour conséquence des risques de mauvaises adhésion.

En pratique, et notamment lorsque le masque dur est conducteur, et typiquement à base de chrome, on peut procéder à l'élimination de ce masque dur, avant le dépôt de la couche barrière à la diffusion du cuivre, de façon à éliminer toute zone conductrice entre spires.

Selon une autre caractéristique de l'invention, on dépose une couche formant barrière à la diffusion du cuivre au-dessus de la couche de matériau de faible permittivité relative, lorsque le masque dur a été éliminé. Cette couche barrière permet d'isoler la couche sous-jacente du cuivre qui va être ultérieurement déposée, notamment sous la forme de la couche amorce. Cette couche barrière caractéristique évite la migration du cuivre à travers la couche de faible permittivité relative, ce qui aurait pour effet d'augmenter cette permittivité, et donc d'augmenter la capacité parasite entre le micro-composant inductif et le substrat et créer des sources de défectivité. Cette couche barrière évite également que le cuivre ne vienne migrer à l'intérieur du substrat, avec des conséquences préjudiciables sur la qualité ou le fonctionnement du circuit intégré.

En pratique, la couche barrière peut être réalisée en tungstène ou à partir d'un matériau choisi dans le groupe comprenant TiW, Ti, TiN, Ta, TaN, Mo, WN, Ru, Re, Cr, Os . Ces matériaux peuvent être utilisés seuls ou en combinaison.

Avantageusement en pratique, la couche barrière à la diffusion peut présenter une épaisseur comprise entre 100 et 400 Å.

Selon une autre caractéristique de l'invention, le procédé peut comporter une étape d'enrichissement de la couche amorce de cuivre. Cette couche amorce joue le rôle d'électrode pour les dépôts ultérieurs de cuivre par voie électrolytique.

Il peut s'avérer utile dans certaines conditions, d'améliorer la régularité et la morphologie, l'état d'oxydation du cuivre, la rugosité et le déficit de sites de nucléation de la couche amorce. Cette couche amorce est déposée par voie physico-chimique et plus particulièrement par la technique dite de pulvérisation et selon sa variante de métal ionisé à source plasma. Dans ce cas, on procède à une étape d'enrichissement de cette couche amorce en soumettant la couche amorce à un bain d'électrolytes. Ce bain comprenant des sels de cuivre permet un dépôt de cuivre dans les éventuels espaces existants entre les îlots de cuivre préalablement déposés lors de la réalisation de la couche amorce. Cette étape d'enrichissement assure donc un lissage de cette couche amorce de manière à améliorer le dépôt électrolytique ultérieur.

Avantageusement en pratique, on peut procéder à une étape de recuit, permettant de faire croître la taille des cristaux de cuivre déposés lors des étapes de dépôt électrolytique. Cette étape de recuit, typiquement par exposition du composant à une température comprise entre 150 et 400°C pendant une durée de quelques minutes, assure une uniformité cristalline du cuivre déposé, et donc l'homogénéité et le caractère conducteur du cuivre qui formera les spires du composant inductif. On améliore ainsi les qualités électriques du composant en diminuant le nombre de singularités pouvant être la source de points résistifs ou de faiblesses mécaniques.

Avantageusement en pratique, on peut procéder à une étape de décontamination du cuivre susceptible de migrer dans le substrat, notamment au niveau des faces latérales et postérieures du substrat ainsi qu'à sa circonférence. En effet, lorsque le composant est soumis à un bain contenant des sels de cuivre solubles dans un solvant judicieusement choisi, il convient d'éliminer un excès de dépôt de cuivre. En effet, lorsque ce métal est déposé selon des techniques d'électrolyse et selon une distribution spécifique de courant entre la cathode et l'anode, on observe généralement un excès de dépôt de cuivre en circonférence du substrat. Par ailleurs, le processus de convection et de transfert de masse, qui est à la base de la technique de dépôt par électrolyse de l'élément Cuivre, engendre sur les faces latérales ou postérieure du substrat un flux possible et une diffusion sur certaines zones du substrat. Afin d'éviter leur éventuelle migration dans le substrat il est recommandé d'utiliser cette étape.

En pratique, cette étape de décontamination peut avoir lieu après l'une et l'autre des deux étapes de dépôt électrolytique.

En pratique, le masque de protection déposé lors de l'étape suivant le dépôt de couches amorces de cuivre, peut être formé d'une résine photonégative. Ceci permet son élimination de façon aisée au fond du trou d'interconnexion dans lequel aura lieu ultérieurement le premier dépôt électrolytique de cuivre. La modification des propriétés de la résine photosensible permet de la durcir sur les zones exposées lors de l'exposition du masque de lithographie. On évite ainsi un dépôt de cuivre en surface, grâce à l'écran ainsi formé à la surface de la couche amorce enrichie par la résine durcie.

Avantageusement en pratique, avant l'étape de dépôt de la résine supérieure, on peut procéder à un traitement utilisant au choix soit l'hexaméthyledisilazane (HMDS) soit le divinyltetramethyldisilazane (DVTMDS). Ce traitement permet de conférer des propriétés de bonne adhésion du cuivre sur la résine, ce qui améliore la croissance du cuivre sur les flancs verticaux des canaux destinés à recevoir les spires.

Selon d'autres caractéristiques de l'invention, on peut procéder à certaines étapes de nettoyage par voie chimique non corrosive vis à vis du cuivre. Ces étapes de nettoyage peuvent intervenir postérieurement au dépôt électrolytique de cuivre, ainsi qu'après l'étape de dépôt de la couche amorce de cuivre, ou bien encore le dépôt de la couche barrière à diffusion du cuivre.

L'invention concerne également un micro-composant électronique pouvant être réalisé selon le procédé exposé ci-avant. Un tel composant incorpore un micro-composant inductif situé sur un substrat, et relié à ce dernier par au moins un plot métallique.

Ce composant comporte
- une couche de matériau à faible permittivité relative, reposant sur la face supérieure du substrat ;
- un ensemble de spires métalliques, définies au-dessus de la couche de matériau à faible permittivité relative ;
- une couche barrière à la diffusion du cuivre, interposée entre les spires métalliques et la couche de matériau à faible permittivité relative.

### Description sommaire des figures

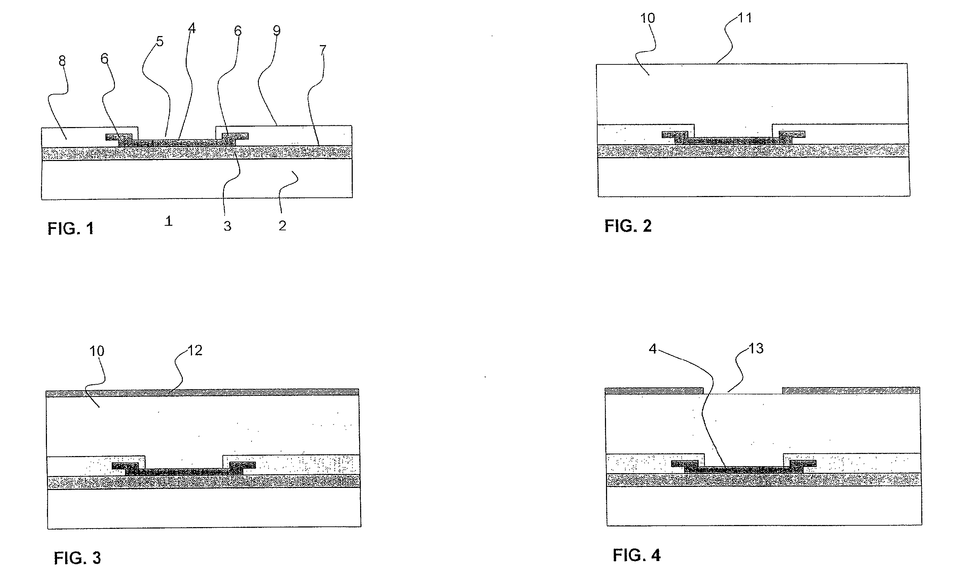

La manière de réaliser l'invention ainsi que les avantages qui en découlent ressortiront bien de la description de l'exemple de réalisation qui suit, à l'appui des figures 1 à 19 annexées, qui sont des représentations en coupe, au niveau d'un plot de connexion, du substrat et des différentes couches qui sont déposées au fur et à mesure des étapes du procédé. Les épaisseurs des différentes couches illustrées aux figures sont données pour permettre la compréhension de l'invention, et ne sont pas toujours en rapport avec les épaisseurs et dimensions réelles.

### Manière de réaliser l'invention

Comme déjà évoqué, l'invention concerne un procédé permettant de réaliser des micro-composants inductifs sur un substrat. Dans l'exemple illustré aux figures, le substrat (1) utilisé est un substrat ayant préalablement été traité de manière à former un circuit intégré. Néanmoins, d'autres substrats différents peuvent être utilisés, tel que notamment des substrats à base de quartz ou de verre.

Ainsi, un tel substrat (1), comme illustré à la figure 1 comporte le niveau supérieur (2) du circuit intégré proprement dit, surmonté d'une couche (3) de substrat dopé.

Dans la figure représentée, le substrat (1) comporte également un plot métallique (4), réalisé en un métal lequel peut être en aluminium ou un alliage d'aluminium ou en cuivre dont la face supérieure (5) est accessible. Les bords (6) de ce plot métallique, ainsi que la face supérieure (7) de la couche dopée sont recouverts d'une couche de passivation (8).

Le procédé conforme à l'invention peut enchaîner les différentes étapes décrites ci-après, étant entendu que certaines peuvent être réalisées de façon différente, tout en obtenant des résultats analogues. Certaines étapes peuvent être également considérées comme utiles mais non indispensables, et donc à ce titre être omises sans sortir du cadre de l'invention.

### Etape n° 1

La première étape consiste à assurer un nettoyage de la face supérieure (5) du plot de connexion métallique (4) ainsi que de la couche de passivation (8) déposée sur le substrat. Ce nettoyage se réalise par voie chimique humide.

### Etape n° 2

Comme illustré à la figure 2, on procède par la suite au dépôt d'une couche (10) de benzocyclobutène (BCB), ou d'un éventuel matériau équivalent, possédant une permittivité relative inférieure à 3. Ce dépôt est effectué par un procédé dit de "dépôt par rotation", également appelé "Spin on deposition". L'épaisseur déposée est voisine de 20 micromètres.

### Etape n° 3

On procède par la suite à un nettoyage de la face supérieure (11) de la couche (10) de BCB. Ce nettoyage, effectué avec un bain approprié, assure le nettoyage et la préparation de la face supérieure (11) de la couche de BCB (10).

### Etape n° 4

Comme illustré à la figure 3, on procède par la suite au dépôt d'une couche (12) formant un masque dur au-dessus de la couche de BCB (10). Cette couche (12) présente une épaisseur de l'ordre de 200 Å. Le matériau employé est préférentiellement du carbure de silicium (SiC), mais il pourrait être également du SiOC, SiN, Si₃N₄, SiON, SiO₄, SiO₂, Cr ou de l'Y₂ O₃ ou tout autre matériau, dès lors que la sélectivité de gravure par rapport au matériau de la couche inférieure est au moins de 10 : 1. Cette couche (12) de masque dur peut être déposée par un procédé de dépôt chimique en phase vapeur assisté par plasma, ou PECVD pour "Plasma Enhanced Chemical Vapor Deposition".

### Etape n° 5

Par la suite, on réalise une ouverture (13) dans le masque dur (12), comme illustré à la figure 4, par un procédé de lithographie et une gravure chimique appropriée utilisant un procédé par voie humide tel qu'un bain à base d'acide hypophosphorique à la température de 180°C, si le masque dur est composé de nitrure de silicium, ou une gravure sèche par plasma utilisant un gaz réactif comportant du fluorine tel que le CF₄ :H₂ par exemple.

### Etape n° 6

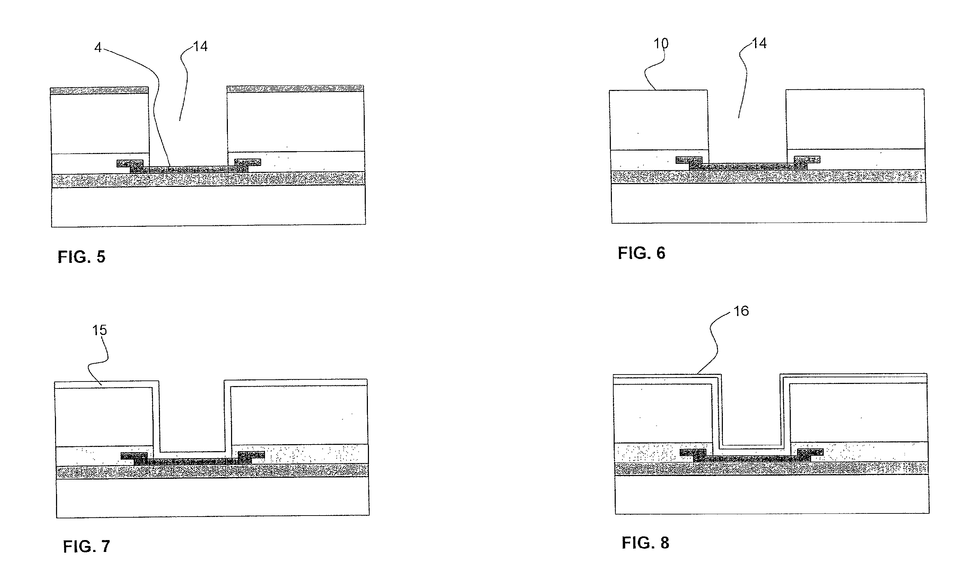

Par la suite, on procède comme illustré à la figure 5, à la gravure de la couche de BCB (10), à l'aplomb du plot métallique de connexion (4), de manière à former le trou d'interconnexion (14), également appelé via. La gravure de la couche de BCB peut s'effectuer notamment par l'emploi d'un mélange de gaz tel que le mélange Ar/CF₄/O₂ ou bien encore par un plasma radiofréquence utilisant d'autres réactants.

### Etape n° 7

Par la suite, comme illustré à la figure 6, on procède à l'élimination du masque dur qui demeurait sur les parties restantes de la couche de BCB (10). L'élimination de ce masque dur s'effectue par décapage, grâce à l'emploi d'une solution composée de Ce(SO4)₂; 2(NH4)₂SO₄ : HClO₄ : Eau désionisée si le masque dur est en chrome par exemple. Le masque dur peut également ne pas être éliminé, et donc conservé sur la couche (10) de BCB, en fonction du matériau qui le constitue, et notamment s'il s'agit de SiC, SiN ou SiON par exemple.

### Etape n° 8

On peut procéder par la suite à un nettoyage du trou d'interconnexion (14) selon différents procédés. Ainsi, il peut s'agir d'un nettoyage par voie chimique, mettant en oeuvre un mélange semi-aqueux non corrosif. On peut également assurer un nettoyage par voie sèche, en utilisant un plasma d'argon, sous une puissance de l'ordre de 300 kilowatts, en soumettant la zone (14) à des ondes radiofréquences pendant une durée voisine de la minute, et à température ambiante.

### Etape n° 9

Comme illustré à la figure 7, on procède par la suite au dépôt d'une couche (15) barrière à la diffusion du cuivre. Cette couche (15) est préférentiellement en en un alliage de Titane et Tungstène, ou bien en une superposition de Titane et de Nitrure de Titane, ou bien encore de Tantale et de Nitrure de Tantale. Cette couche (15) peut également être réalisée en Nitrure de Tungstène, ou bien par une simple couche de Tungstène, de Molybdène, d'Osmium, ou de Ruthénium. Cette couche (15), d'une épaisseur comprise entre 100 et 400 Å, peut être déposée par différentes techniques, et notamment par pulvérisation, procédé également connu sous l'abréviation de PVD - IMP pour "Physical Vapor Deposition - Ionized Metal Plasma", ou par des techniques de dépôt chimique en phase vapeur connue sous le nom de CVD « Chemical Vapor Deposition» et ALD « Atomic Layer Déposition ».

### Etape n° 10

Comme illustré à la figure 8, on procède par la suite au dépôt d'une couche (16) amorce de cuivre. Cette couche amorce (16) peut être déposée par différentes techniques, et notamment par pulvérisation, procédé également connu sous l'abréviation de PVD - IMP pour "Physical Vapor Deposition - Ionized Metal Plasma", ou par des techniques de dépôt chimique en phase vapeur connue sous le nom de CVD « Chemical Vapor Deposition» et ALD « Atomic Layer Deposition La couche ainsi obtenue présente une épaisseur comprise typiquement entre 500 et 2000 Å.

### Etape n° 11

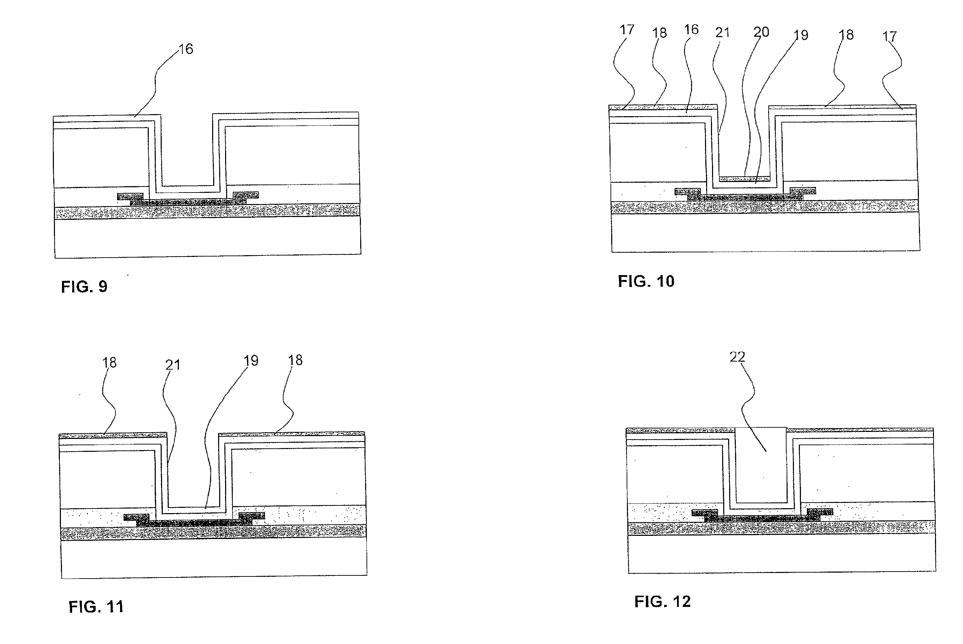

Par la suite, et comme illustré à la figure 9, on procède à une étape d'enrichissement de la couche amorce (16) par voie électrolytique. On peut utiliser un bain des sels de cuivre, tels que CuSO₄:5H₂O. On peut également procéder par apport d'un agent réducteur tel que du diméthylamineborane, en substitution du courant électrolytique.

Cette étape d'enrichissement permet de combler les espaces entre les îlots de cuivre qui ont été préalablement déposés pour former la couche amorce. La surface de la couche amorce (16) est donc ainsi lissée, ce qui favorise l'étape ultérieure de dépôt électrolytique. Cette étape permet d'augmenter l'épaisseur de la couche amorce à l'intérieur de la via et plus particulièrement sur les faces intérieures et au fond du trou d'interconnexion.

### Etape n° 12

Par la suite, comme illustré à la figure 10, on dépose sur les faces (17) de la couche amorce (16) parallèles au substrat, une couche (18) de résine photonégative. Ce dépôt (20) a également eu lieu dans le fond (19) du trou d'interconnexion, mais pas sur les parois verticales (21) de ce même trou. Cette couche (18,20) de résine photonégative présente une épaisseur de l'ordre de 5 000 Å.

### Etape n° 13

Par la suite, comme illustré à la figure 11, on procède à l'élimination de la couche (20) de résine photo négative située au fond (17) du trou d'interconnexion (14). Le reste (18) de la résine photo-négative n'est pas éliminée par suite du processus de photo exposition ce qui durcit la résine exposée.

### Etape n° 14

Par la suite, on procède à une étape de nettoyage par application d'une solution non corrosive pour le cuivre, de manière à obtenir un état de surface optimal en ce qui concerne le fond (19) du trou d'interconnexion ainsi que ses parois latérales (21). Le bain utilisé est une solution aqueuse et peut contenir des molécules inhibitrices de corrosion telles que du benzotriazole.

### Etape n° 15

Comme illustré à la figure 12, on procède par la suite à un dépôt électrolytique de cuivre, de manière à assurer un remplissage (22) du trou d'interconnexion (14) par une technique connue sous le nom « electroplating ». Cette technique est basée sur l'utilisation d'un bain d'électrolytes dont la formulation est judicieusement définie pour obtenir une qualité de Cuivre optimale, à savoir une résistivité avant croissance des grains lors d'un recuit compris entre 1,9µΩ.cm et 2,3µΩ.cm et préférentiellement compris entre 2µΩ.cm et 2,15µΩ.cm. Par ailleurs, la définition du dépôt est directement fonction de la géométrie de la cellule électrochimique, de la distance entre la cathode et l'anode, de la forme et des caractéristiques de chaque électrode ainsi que de la zone et de la surface sur laquelle on va déposer. Les bains utilisés peuvent être par exemple ceux commercialisés sous la dénomination "Cu VIAFORM" par la société ENTHONE, ou "Cu GLEAM ELECTRODEPOSIT 6000" par la société SHIPLEY.

### Etape n° 16

Par la suite on peut procéder à une étape de décontamination, permettant d'éliminer toute trace de cuivre qui serait susceptible de venir migrer dans le substrat ou dans tout autre partie sur laquelle les ions de cuivre ont pu se déposer. Cette étape de décontamination permet notamment de nettoyer l'arrière du substrat, ainsi que les zones périphériques du substrat. Parmi ces zones périphériques, on entend les faces latérales du substrat, perpendiculaires au plan principal du substrat ainsi que les arêtes du substrat sur lesquelles ont pu venir s'accumuler des dépôts superflus de cuivre liés au processus de dépôt du cuivre selon la technique utilisée.

Cette étape de décontamination s'effectue par voie chimique et humide au moyen d'outil permettant le traitement face par face du substrat, en utilisant un bain contenant un mélange de péroxyde d'hydrogène et d'acide sulfurique.

### Etape n° 17

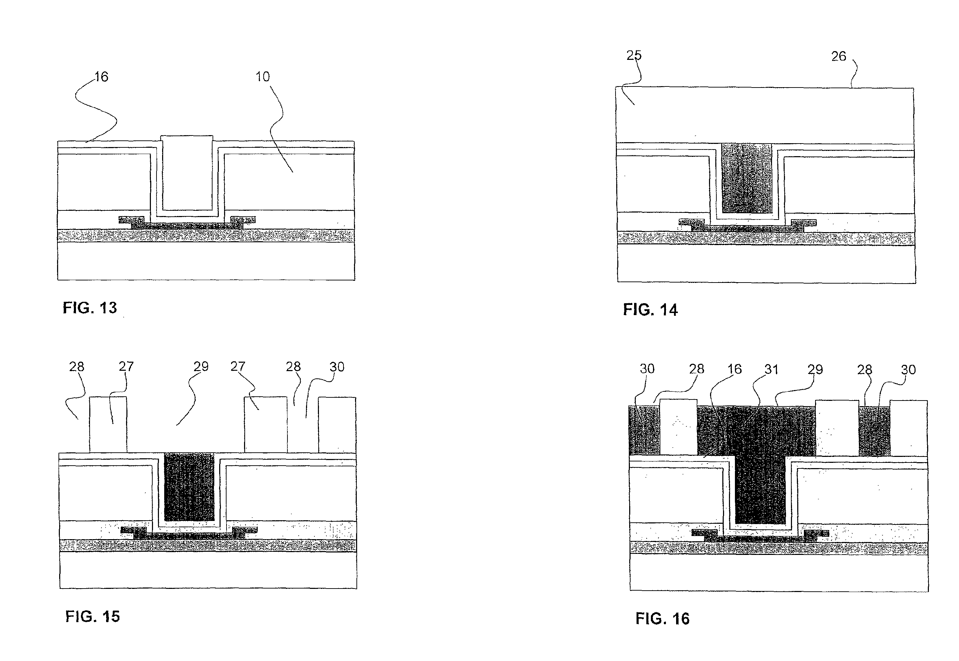

Par la suite, on procède comme illustré à la figure 13 à l'élimination par décapage du masque de résine photo négative qui protégeait la couche amorce de cuivre au-dessus des zones de BCB (10).

### Etape n° 18

On procède par la suite à une étape de nettoyage par application d'un bain non corrosif pour le cuivre, de manière à éliminer toute trace de résine sur la couche amorce (10), en vue de faciliter le dépôt des couches ultérieures.

### Etape n° 19

On procède par la suite à une étape dite de "recuit", permettant de réorganiser la structure cristalline du cuivre (22) déposé dans le trou d'interconnexion (14), en faisant croître la taille des grains élémentaires cristallins. Cette étape utilise une technique connue sous le nom de "RTP" pour "Rapid Thermal Processing" pendant laquelle le composant est soumis à une température de l'ordre de 150 à 400° C, voisine préférentiellement de 300°C, pendant une durée de 10 secondes à 30 minutes et préférentiellement pendant 5 minutes. Le composant est maintenu sous une atmosphère d'un gaz inerte ou bien sous vide évitant toute oxydation et diffusion de l'oxygène dans le milieu cristallin du cuivre. La définition des paramètres est judicieusement choisie pour obtenir une qualité de Cuivre optimale à savoir une résistivité après croissance des grains compris entre 1,7µΩ.cm et 2µΩ.cm mais préférentiellement compris entre 1,72µΩ.cm et 1,82µΩ.cm.

### Etape n° 20

On procède ensuite à un étalement par effet centrifuge soit d'hexaméthyledisilazane (HMDS) soit le divinyltétramethyldisilazane (DVTMDS). Ceci permet d'optimiser l'état de surface des flancs verticaux de la résine qui sera déposée ultérieurement, et dans laquelle pourront diffuser l'HDMS ou le DVTMDS lors des étapes de recuit, car ces additifs abaissent la tension de surface de cette résine. Ce traitement favorise une meilleure adhésion du cuivre sur les flancs verticaux de la résine déposée ultérieurement, et qui forment les parois de la via (14).

### Etape n° 21

Par la suite, on procède au dépôt d'une couche (25) de résine supérieure, comme illustrée à la figure 14. Cette résine (25) est du type photosensible positive, pour permettre les lithographies ultérieures. Cette résine (25) résiste aux chimies acides des dépôts électrolytiques.

La couche (25) de résine supérieure ainsi déposée présente une épaisseur comprise entre 10 et 50 microns, préférentiellement comprise entre 20 et 40 microns, en fonction de la hauteur des spires du composant inductif.

### Etape n° 22

Par la suite, comme illustré à la figure 15, on procède à la gravure de cette couche de résine supérieure (25) pour définir entre les zones restantes (27) des canaux (28,29) qui recevront ultérieurement le cuivre qui formera les spires du composant inductif. Cette gravure s'effectue par un procédé de lithographie standard.

### Etape n° 23

Par la suite, et comme illustré à la figure 16, on procède à un dépôt électrolytique de cuivre, au-dessus de la couche amorce (16). On notera que l'épaisseur déposée dans les canaux périphériques (28) est la même que celle dans le canal (29) situé à l'aplomb du trou d'interconnexion (4), de sorte que la croissance est sensiblement similaire. Le dépôt électrolytique du cuivre peut dans ce cas précisément se faire au moyen d'un outil de dépôt électrochimique utilisant une anode soluble de cuivre et un bain chimique choisi parmi les différents producteurs tels que le bain «Cu gleam electrodeposit 6000» commercialisé par la société Shipley. Le dépôt de cuivre remplit typiquement entre 70% et 90% des canaux (29), de manière à donner des épaisseurs de cuivre pour les spires supérieures à 10 micromètres.

### Etape n° 24

Par la suite, on procède à une étape de décontamination identique à celle décrite à l'étape n° 16.

### Etape n° 25

Par la suite, on procède à l'élimination des zones (27) de résine supérieure qui définissaient les différents canaux (28,29). L'élimination de cette résine (27) permet de libérer l'espace (32) entre spires (30-31), de manière à limiter la capacité entre spires. Cette élimination permet également de rendre accessible les couches métalliques (16,15) situées entre les spires (30-31) en vue de leur future élimination.

### Etape n° 26

Par la suite, on procède comme déjà évoqué à l'étape n° 18 à une étape de nettoyage par l'application d'un bain non corrosif pour le cuivre afin de retirer tous les résidus engendrés par l'étape de lithographie dont le procédé chimique peut utiliser un composé d'amines et de molécules anti-corrosives du cuivre choisi parmi les fabricants de tels produits comme le produit ACT-970 de la société Ashland.

### Etape n° 27

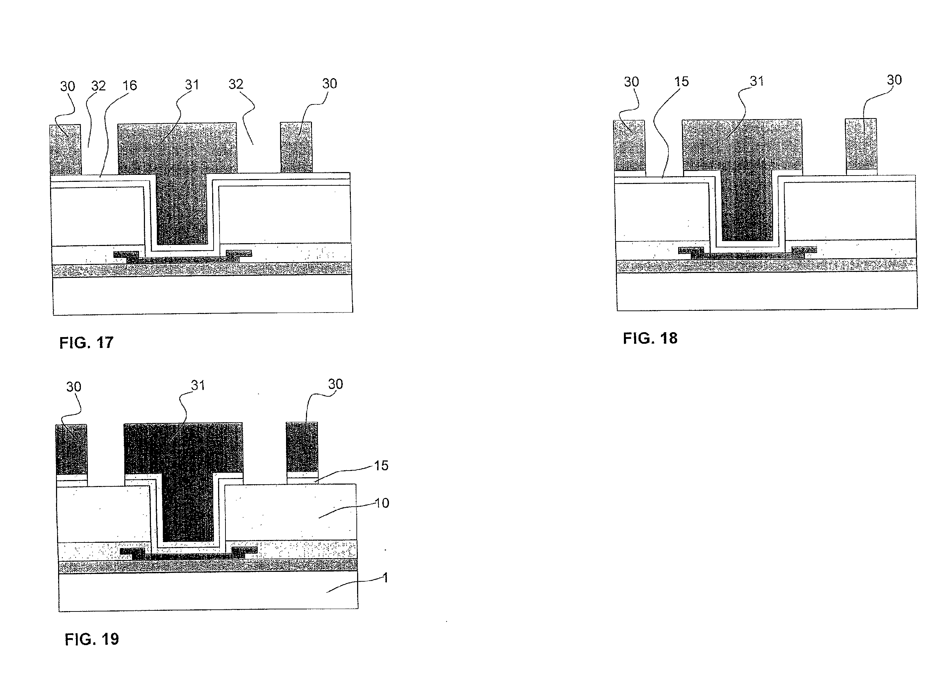

Par la suite, on procède comme illustré à la figure 18, à une gravure humide anisotrope de la couche amorce de cuivre (16) , par exemple grâce à un bain d'acide sulfurique, ou un bain d'acide nitrique incluant du benzotriazole.

### Etape n° 28

Par la suite, on procède comme illustré à la figure 19 à la gravure de la couche (15) barrière à la diffusion du cuivre qui est dépendant du choix du matériau de barrière de diffusion du cuivre. A titre d'exemple, lorsque la couche barrière de diffusion est une superposition de deux couches de Titane et de Nitrure de Titane, cette barrière de diffusion peut être gravée par une solution aqueuse composée d'éthylène diamine tétra acétique acide (EDTA) et de peroxyde d'hydrogène selon un ratio de 2 pour 1, à une température comprise entre 45°C et 90°C et préférentiellement, voisine de 65°C. Mais cet exemple n'est pas limitatif et d'autres bains chimiques peuvent être utilisés selon l'état de l'art de la technique.

De la sorte, les différentes spires (30) et la partie centrale (31) du micro-composant inductif sont donc électriquement indépendantes.

### Etape n° 29

Par la suite, on procède à une étape de recuit analogue à celle décrite à l'étape n° 19.

### Etape n° 30

Par la suite, on procède à une étape de nettoyage par un bain non corrosif pour le cuivre tel qu'analogue à celui décrit dans les étapes n° 18 et 26.

Il ressort de ce qui précède que le procédé conforme à l'invention permet d'obtenir des micro-composants inductifs qui présentent un très fort facteur de qualité, du fait d'un éloignement maîtrisé entre le substrat et le plan principal du micro-composant inductif. Typiquement, les facteurs de qualité obtenus sont supérieures à 40, à des fréquences de l'ordre de 2 GigaHertz.

La décomposition du dépôt électrolytique de cuivre en deux étapes distinctes permet d'assurer une optimisation de la régularité de la forme des différentes spires sans augmentation du coût de fabrication, et ainsi donc une bonne reproductibilité du procédé conduisant à la réalisation de micro-composant possédant des caractéristiques électriques très proches de celles définies lors de la conception et donc des performances électriques attendues.

Par ailleurs l'avantage de cette présente invention est de maîtriser les interfaces entre les différentes couches de matériaux déposés et formés ce qui a pour conséquence une nette amélioration des performances du dispositif et une nette réduction des sources de défectivité.

## Revendications

1. Procédé de fabrication d'un composant électronique, incorporant un micro-composant inductif situé au-dessus d'un substrat (1), et relié à ce dernier par au moins un plot métallique (4), **caractérisé en ce qu'**il comporte les étapes suivantes, consistant successivement à :
a) déposer sur le substrat (1) une couche (10) de matériau à faible permittivité relative ;
b) déposer une couche (12) formant un masque dur ;
c) réaliser une ouverture (13) dans le masque dur (12), à l'aplomb des plots métalliques (4) ;
d) graver la couche (10) de matériau à faible permittivité relative jusqu'au plot métallique, pour former un trou d'interconnexion (14);
e) déposer une couche (15) formant barrière à la diffusion du cuivre ;
f) déposer une couche amorce de cuivre ;
g) déposer un masque de protection (18,20), et à l'éliminer au niveau du fond (19) du trou d'interconnexion (14) ;
h) déposer du cuivre, par voie électrolytique, dans le trou d'interconnexion (14);
i) éliminer le reste (18) du masque de protection ;
j) déposer une couche de résine supérieure (25) d'une épaisseur voisine de l'épaisseur des spires (30) du micro-composant inductif;
k) graver la couche de résine (25) pour former des canaux (32) définissant la géométrie des spires du micro-composant inductif ;
l) déposer du cuivre par voie électrolytique dans les canaux (32) ainsi gravés ;
m) éliminer le reste (27) de la couche (25) de résine supérieure ;
n) graver 1a couche (16) amorce de cuivre entre les spires de cuivre (30-31) ;
o) graver la couche (15) barrière à la diffusion du cuivre entre les spires (30) du micro-composant inductif ;

2. Procédé selon la revendication 1, **caractérisé en ce que** le substrat (1) est un substrat semi-conducteur, formant un circuit intégré.

3. Procédé selon la revendication 1, **caractérisé en ce que** le substrat est un substrat amorphe du type verre ou quartz.

4. Procédé selon la revendication 1, **caractérisé en ce que** le matériau (10) de faible permittivité relative, déposé sur le substrat est du benzocyclobutène.

5. Procédé selon la revendication 1, **caractérisé en ce que** l'épaisseur de la couche (10) de matériau de faible permittivité relative est comprise entre 10 et 40 micromètres, préférentiellement voisine de 20 micromètres.

6. Procédé selon la revendication 1, **caractérisé en ce que** le matériau utilisé pour la couche (12) formant le masque dur est choisi dans le groupe comprenant : SiC, SiN, Si₃N₄, SiON, SiO₂, SiOC, Y₂O₃, Cr pris isolément ou en combinaison.

7. Procédé selon la revendication 1, dans lequel le masque dur (12) est réalisé en Chrome, **caractérisé en ce qu'**il comporte également une étape d'élimination du masque dur (12) avant le dépôt de la couche (15) formant barrière à la diffusion du cuivre.

8. Procédé selon la revendication 1, **caractérisé en ce que** le matériau utilisé pour la couche (15) barrière à la diffusion du cuivre est choisi dans le groupe comprenant TiW, Ti, TiN, Ta, TaN, W, WN, Re, Cr, Os, Mo, Ru, pris isolément ou en combinaison.

9. Procédé selon la revendication 1, **caractérisé en ce que** l'épaisseur de la couche (15) barrière à la diffusion du cuivre est comprise entre 100 et 400 Å.

10. Procédé selon la revendication 1, **caractérisé en ce qu**'il comporte une étape d'enrichissement de la couche (16) amorce de cuivre.

11. Procédé selon la revendication 1, **caractérisé en ce qu'**il comporte une étape de recuit, destinée à faire croître la taille des cristaux de cuivre déposés lors des étapes de dépôt électrolytique.

12. Procédé selon la revendication 1, **caractérisé en ce qu'**il comporte une étape de décontamination du cuivre susceptible de migrer dans le substrat (1), notamment au niveau des faces latérales du substrat.

13. Procédé selon la revendication 12, **caractérisé en ce que** l'étape de décontamination a lieu à la suite d'au moins une des étapes de dépôt électrolytique de cuivre.

14. Procédé selon la revendication 1, **caractérisé en ce que** le masque(18,20) de protection déposé lors de l'étape suivant le dépôt de la couche (16) amorce de cuivre est formé d'une résine photonégative.

15. Procédé selon la revendication 1, **caractérisé en ce qu'**avant l'étape de dépôt de la couche (25) de résine supérieure, on procède à un traitement à l'hexaméthyldisiazane (HMDS) ou au divinyltétramethyldisilazane (DVTMDS), destiné à conférer des propriétés de bonne adhésion du cuivre sur ladite résine supérieure (25).

16. Procédé selon la revendication 1, **caractérisé en ce qu'**il comporte au moins une étape de nettoyage par voie chimique non corrosive vis à vis du cuivre postérieurement aux dépôts électrolytiques de cuivre, et/ou aux étapes de dépôt de la couche amorce de cuivre, et /ou de la couche barrière à la diffusion du cuivre.

17. Procédé selon la revendication 1, **caractérisé en ce que** le dépôt de cuivre destiné à former les spires est effectué pour donner un épaisseur de cuivre supérieure à 10 micromètres.

18. Composant électronique, incorporant un micro-composant inductif situé au-dessus d'un substrat (1), relié à ce dernier par au moins un plot métallique (4), **caractérisé en ce qu**'il comporte :
- une couche (10) de matériau à faible permittivité relative, reposant sur la face supérieure du substrat (1) ;
- un ensemble de spires métalliques (30-31), définies au-dessus de la couche (10) de matériau à faible permittivité relative ;
- une couche (15) barrière à la diffusion du cuivre, interposée entre les spires métalliques (30-31) et la couche de matériau à faible permittivité relative.

19. Composant selon la revendication 18, **caractérisé en ce que** le substrat est un substrat semi-conducteur, formant un circuit intégré.

20. Composant selon la revendication 18, **caractérisé en ce que** le substrat est un substrat amorphe du type verre ou quartz.

21. Composant selon la revendication 18, **caractérisé en ce que** le matériau de faible permittivité relative déposé sur le substrat est du benzocyclobutène.

22. Composant selon la revendication 21, **caractérisé en ce que** l'épaisseur de la couche d'un matériau de faible permittivité relative est comprise entre 10 et 40 micromètres, de préférence voisine de 20 micromètres.

23. Composant selon la revendication 18, **caractérisé en ce que** le matériau utilisé pour la couche barrière à la diffusion du cuivre est choisi dans le groupe comprenant TiW, Ti, TiN, Ta, TaN, W, WN, Re, Cr, Os, Mo et Ru, pris isolément ou en combinaison.

24. Composant selon la revendication 18, **caractérisé en ce que** l'épaisseur de la couche barrière à la diffusion du cuivre est comprise entre 100 et 400 Å.

25. Composant selon la revendication 18, **caractérisé en ce que** l'épaisseur des spires (30,31) est supérieure à 10 micromètres.

26. Composant selon la revendication 18, **caractérisé en ce que** le facteur de qualité du micro-composant inductif est supérieur à 40, à 2 GigaHertz.

27. Composant selon la revendication 18, **caractérisé en ce que** la résistivité des spires est comprise entre 1,72 µΩ.cm et 1,82 µΩ.cm.
